# EUROPÄISCHE PATENTSCHRIFT

(11) **EP 2 992 594 B1**
(45) Veröffentlichungstag und Bekanntmachung des Hinweises auf die Patenterteilung: **13.11.2019**
(21) Anmeldenummer: 14710897.1
(22) Anmeldetag: 18.03.2014
(51) Int. Cl.: H02K 11/00, H05K 7/14, H05K 5/00

(54) **GEHÄUSEANORDNUNG MIT EINEM GEHÄUSEBAUTEIL FÜR EINE ELEKTRISCHE MASCHINE UND EINER ELEKTRISCHEN LEITERPLATTE**
HOUSING ASSEMBLY HAVING A HOUSING COMPONENT FOR AN ELECTRICAL MACHINE AND AN ELECTRICAL CIRCUIT BOARD
DISPOSITIF DE BOÎTIER COMPORTANT UN COMPOSANT DE BOÎTIER POUR UN MOTEUR ÉLECTRIQUE ET UNE CARTE DE CIRCUITS IMPRIMÉS ÉLECTRIQUE

(30) Priorität: 03.05.2013 DE 102013208177
(43) Veröffentlichungstag der Anmeldung: 09.03.2016
(73) Patentinhaber: Robert Bosch GmbH, 70442 Stuttgart (DE)
(72) Erfinder: MEYER, Christian, 76228 Karlsruhe-Wolfartsweier (DE)
(86) Internationale Anmeldenummer: PCT/EP2014/055444
(87) Internationale Veröffentlichungsnummer: WO 2014/177320

(56) Entgegenhaltungen:
- GB-A- 2 111 579
- US-A- 3 777 052
- US-A- 4 781 488
- US-A1- 2012 139 371

## Beschreibung

### Stand der Technik

Die vorliegende Erfindung geht aus von einem Gehäusebauteil für eine elektrische Maschine nach der Gattung des unabhängigen Patentanspruchs 1.

Elektrische Leiterplatten werden in mechanischen Bauteilen wie beispielsweise in Gehäusen befestigt, indem sie durch Stifte, beispielsweise die Stecker eines elektrischen Anschlusses oder Dome am Gehäuse, positioniert, auf Stege aufgelegt und/oder durch Klemmelemente oder Schnappbügel fixiert werden.

Die Druckschrift mit der Anmeldenummer DE 10 2012 203 946 offenbart eine solche in einem Gehäusebauteil einer elektrischen Maschine angeordnete elektrische Leiterplatte. Um die elektrische Leiterplatte zu positionieren und zu fixieren, ist in dem Gehäuse ein Zentrier- Pin offenbart, auf den die elektrische Leiterplatte in eine Fügerichtung aufgeschoben wird. Nach dem Fügen der elektrischen Leiterplatte wird der Zentrier- Pin plastisch umgeformt, so dass an seinem offenen Ende ein Sicherungskopf gebildet ist, der ein Zurückbewegen der elektrischen Leiterplatte gegen die Fügerichtung verhindert. Das Fixieren der Leiterplatte erfordert daher nach dem Fügen der Leiterplatte den zusätzlichen Arbeitsschritt des plastischen Umformens der Zentrier- Pins.

GB 2 111 579 A und US 4,781,488 zeigen eine Sicherungseinheit mit der zwei unterschiedliche Platten zueinander positioniert werden können.

### Offenbarung der Erfindung

Aufgabe der vorliegenden Erfindung ist es, ein Gehäuseanordnung mit einem Gehäusebauteil und einer elektrischen Leiterplatte zu schaffen, in der die Leiterplatte schnell und einfach sowohl händisch als auch automatisch montierbar ist, wobei ein Durchbiegen der elektrischen Leiterplatte vermieden wird, wobei die Leiterplatte im Gehäusebauteil sicher fixiert ist, wobei Bauraum eingespart wird und wobei möglichst wenig Arbeitsschritte erforderlich sind.

Die Aufgabe wird gelöst mit einem Gehäusebauteil, gemäß Anspruch 1, insbesondere für eine elektrische Vorrichtung, die eine elektrische Maschine umfasst, mit einem Positionierstift zum Anordnen einer elektrischen Leiterplatte in einem Innenraum des Gehäusebauteils, wobei der Positionierstift einen Anschlag zum Begrenzen der Bewegung der Leiterplatte in eine Erstreckungsrichtung des Positionierstiftes aufweist, und wobei er ein Mittel zum Verklemmen der elektrischen Leiterplatte aufweist, das in einem Klemmbereich in Erstreckungsrichtung oberhalb des Anschlags angeordnet ist.

Durch den Positionierstift wird die elektrische Leiterplatte beim Aufschieben in Erstreckungsrichtung nicht nur eingefangen und somit positioniert. Sondern der Positionierstift dient gleichzeitig als Auflage und zum Verklemmen der elektrischen Leiterplatte im Gehäusebauteil. Ein Auflegen der Leiterplatte auf in Erstreckungsrichtung verschieden hoch angeordnete Anschläge und ein daraus gegebenenfalls folgendes Verbiegen der Leiterplatte kann mit dem Positionierstift vermieden werden. Und zudem sind keine zusätzlichen Bauteile zum Auflegen und/oder Fixieren der Leiterplatte im Gehäusebauteil erforderlich.

Dadurch ist die Geometrie des Gehäusebauteils vereinfacht, was zu verringerten Kosten für das Herstellungswerkzeug führt. Zudem wird der Bauraum für die nicht mehr erforderlichen Anschläge und/oder Fixierungsmittel eingespart. Schließlich ermöglichen das Einfangen und gleichzeitige Fixieren der Leiterplatte sowie die durch den Anschlag begrenzte Verschiebemöglichkeit der Leiterplatte in Erstreckungsrichtung nicht nur eine händische sondern auch eine kostengünstige automatisierte Montage.

Der Positionierstift ist bevorzugt aus einem Kunststoff gebildet. Vorzugsweise ist das gesamte Gehäusebauteil, insbesondere einstückig mit dem Positionierstift, aus Kunststoff hergestellt, vorzugsweise aus Polyamid. Es ist bevorzugt, dass der Positionierstift zumindest im Klemmbereich zumindest geringfügig elastisch oder elastisch - plastisch ausgebildet ist. Durch die elastische Eigenschaft ist eine auf den Positionierstift aufgeschobene Leiterplatte nicht mehr beschädigungsfrei vom Positionierstift lösbar.

Das Mittel zum Verklemmen der elektrischen Leiterplatte ist bevorzugt eine Anformung. Durch die Anformung weist der Positionierstift im Klemmbereich bevorzugt einen sich in Umfangsrichtung ändernden Durchmesser auf. Eine solche Anformung ist einstückig mit dem Positionierstift kostengünstig herstellbar. Im Folgenden werden die Begriffe Mittel zum Verklemmen und Anformung synonym verwendet.

Die Anformungen sind als in Erstreckungsrichtung stegförmige Quetschrippen ausgebildet. Die zwischen der Anformung und der Leiterplatte beim Aufschieben entstehende Klemmverbindung ist eine Presspassung.

In einer bevorzugten Ausführungsform weist der Positionierstift mehrere Anformungen auf, die in einer Umfangsrichtung des Positionierstiftes gleichmäßig verteilt angeordnet sind. Diese Ausbildung ermöglicht beim Aufschieben der Leiterplatte auf den Positionierstift einen in Umfangsrichtung um den Positionierstift herum gleichmäßigen in Erstreckungsrichtung wirkenden Druck.

Weiterhin weist der Positionierstift auch mehrere Anschläge auf, die versetzt zu den Anformungen am Positionierstift angeordnet sind. Durch den Versatz gerät ein Abrieb, beispielsweise in Form eines Spans, der gegebenenfalls beim Aufschieben der Leiterplatte auf den Positionierstift entsteht, nicht zwischen den Anschlag und die Leiterplatte.

Erfindungsgemäß weist der Positionierstift zwei einander gegenüberliegende Anformungen und zwei einander gegenüberliegende Anschläge auf, wobei die Anformungen gegenüber den Anschlägen jeweils um einen Versatzwinkel von vorzugsweise etwa 90° zueinander versetzt angeordnet sind. In dieser Ausführungsform ist es zudem bevorzugt, dass das Gehäusebauteil zwei Positionierstifte aufweist. Die beiden Positionierstifte sind bevorzugt um Drehwinkel, insbesondere um 90°, zueinander versetzt angeordnet. Dadurch wird die Leiterplatte in einer Ebene, die durch Linien aufgespannt ist, welche sich in Richtung der Anschläge erstrecken, angeordnet. Dabei wird die Leiterplatte nicht verspannt und ein Durchbiegen der Leiterplatte vermieden.

Die Aufgabe wird weiterhin gelöst mit einer Gehäuseanordnung mit einem solchen Gehäusebauteil und einer elektrischen Leiterplatte, wobei die Leiterplatte eine Durchgangsbohrung aufweist, die der Positionierstift durchgreift.

Es ist bevorzugt, dass der Durchmesser des Positionierstiftes im Bereich der Anformungen jeweils größer als ein Durchmesser der Durchgangsbohrung ist. Außerhalb der Anformungen ist es bevorzugt, dass der Durchmesser des Positionierstiftes kleiner als der Durchmesser der Durchgangsbohrung ist. Dadurch ist die Leiterplatte auf den Positionierstift aufschiebbar, so dass der Positionierstift die Durchgangsbohrung umgreift. Dabei schabt ein Rand der Durchgangsbohrung entlang der oder den Anformungen, wobei gegebenenfalls ein Abrieb entsteht. Der Positionierstift und die Leiterplatte sind dann durch eine Presspassung miteinander verbunden.

Die Aufgabe wird weiterhin gelöst mit einer elektrischen Vorrichtung, die eine elektrische Maschine und eine solche Gehäuseanordnung umfasst, wobei die elektrische Leiterplatte mit der elektrischen Maschine elektrisch verbunden ist. Die elektrische Vorrichtung ist bevorzugt ein Verstellantrieb für ein Kraftfahrzeug, der vorzugsweise zum Verstellen einer Komponente wie beispielsweise eines Fensters, eines Sitzes oder einer Heckklappe vorgesehen ist. Oder ebenfalls bevorzugt ist sie ein Servoantrieb für ein Kraftfahrzeug oder ein Motorraumsteller, mit dem eine Komponente im Motorraum des Kraftfahrzeugs verstellbar oder regelbar ist. In dieser Ausführungsform ist die elektrische Maschine ein Elektromotor, insbesondere ein Gleichstrommotor oder ein Synchronmotor. Ebenfalls bevorzugt ist die elektrische Vorrichtung eine Handwerkzeugmaschine, wobei die elektrische Maschine ein Elektromotor, insbesondere ein Gleichstrommotor oder ein Synchronmotor, ist. Eine solche Handwerkzeugmaschine ist beispielsweise eine Bohrmaschine, eine Stichsäge oder eine elektrische Schere. Die Erfindung umfasst aber auch andere elektrische Vorrichtungen, in denen die elektrische Maschine eine andere Funktion, beispielsweise die eines Generators oder die eines Starters, aufweist.

Die Aufgabe wird weiterhin gelöst mit einem Verfahren zur Herstellen einer solchen elektrischen Vorrichtung, insbesondere eines Verstellantriebs für ein Kraftfahrzeug, mit den Schritten:
- Aufschieben einer elektrischen Leiterplatte auf einen Positionierstift eines Gehäusebauteils in Erstreckungsrichtung des Positionierstiftes, wobei die Leiterplatte am Positionierstift verklemmt wird; und
- Gleichzeitig und/oder anschließend elektrisches Verbinden von elektrischen Kontakten der Leiterplatte mit elektrischen Gegenkontakten, die mit der elektrischen Maschine elektrisch verbunden sind.

Für das elektrische Verbinden der elektrischen Kontakte mit den elektrischen Gegenkontakten sind bevorzugt zumindest teilweise Stiftkontakte vorgesehen. Vorzugsweise werden die Stiftkontakte zumindest teilweise durch Verlöten mit den elektrischen Kontakten oder Gegenkontakten verbunden. In dieser Ausführungsform erfolgt das elektrische Verbinden anschließend durch Verlöten. Dadurch ist die elektrische Leiterplatte auch dann noch sicher im Gehäusebauteil positioniert und fixiert, falls sich die Klemmverbindung zwischen der Durchgangsbohrung der Leiterplatte und dem Positionierstift, beispielsweise durch Erwärmen oder Kriechen des Kunststoffs, lockert oder löst.

Die Erfindung umfasst aber auch andere elektrische Verbindungen wie beispielsweise Federkontakte mit Federkraftklemmen, insbesondere in Direktstecktechnik, oder Federkontakte zu Leiterpads, die auf der Leiterplatte angeordnet sind.

Beim Aufschieben der elektrischen Leiterplatte auf den Positionierstift ist es bevorzugt, dass dieser im Bereich der Anformung zumindest geringfügig elastisch ausgebildet ist. Dadurch wird die Anformung beim Aufschieben teilweise elastisch verformt und gegebenenfalls teilweise abgeschabt. Die Leiterplatte ist dann leichter auf den Stift aufschiebbar, nach dem Aufschieben nicht mehr beschädigungsfrei vom Positionierstift lösbar und eine Spanbildung wird gegebenenfalls vermieden.

Im Folgenden wird die Erfindung anhand von **Figuren** beschrieben. Die **Figuren** sind lediglich beispielhaft und schränken den allgemeinen Erfindungsgedanken nicht ein.

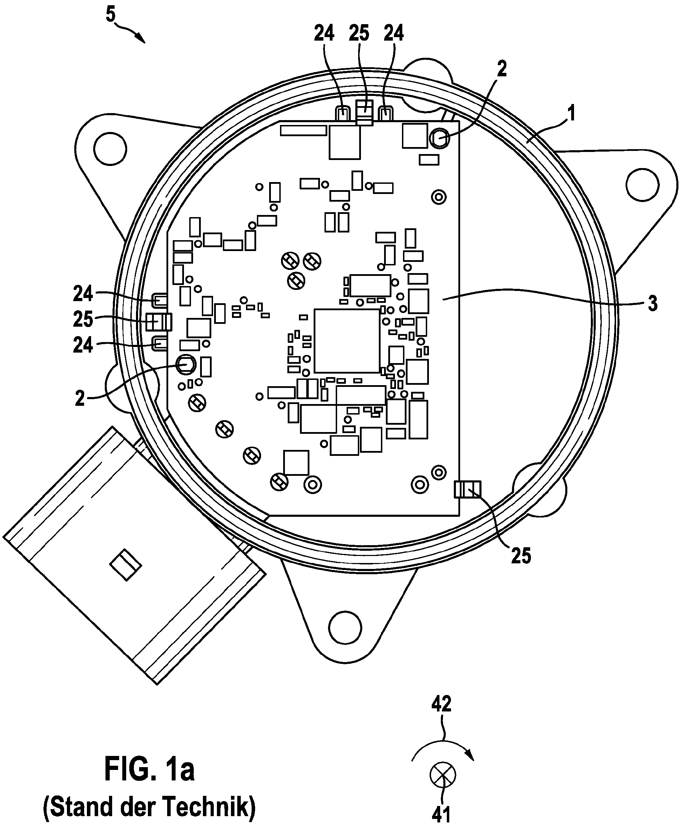

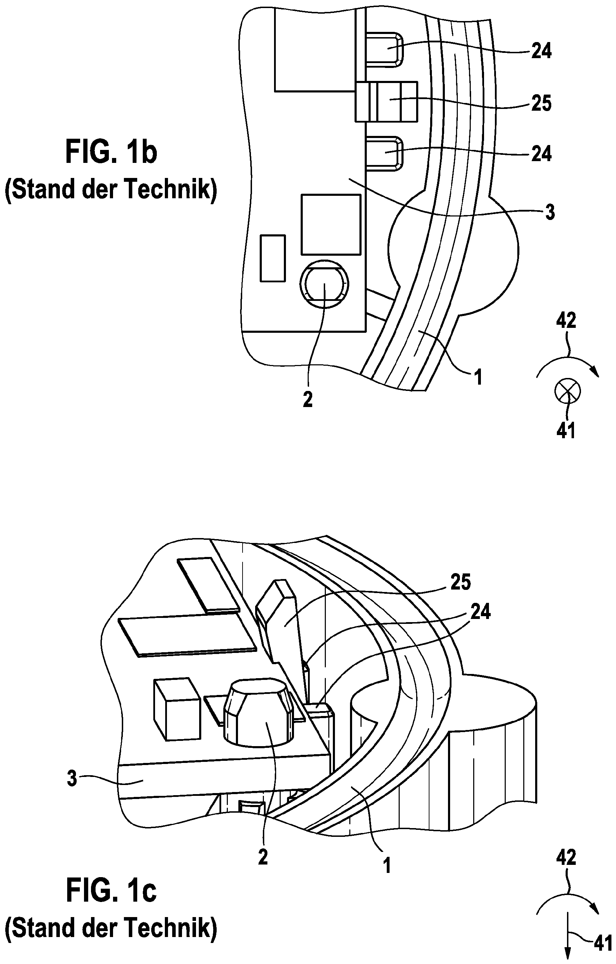

- **Fig. 1**: zeigt in (a) ein Gehäusebauteil für einen Elektromotor eines Verstellantriebs eines Kraftfahrzeugs mit einer elektrischen Leiterplatte von oben, in (b) einen Ausschnitt aus dem Gehäusebauteil von oben und in (c) einen Ausschnitt aus dem Gehäusebauteil in einer perspektivischen Ansicht, jeweils gemäß dem Stand der Technik;

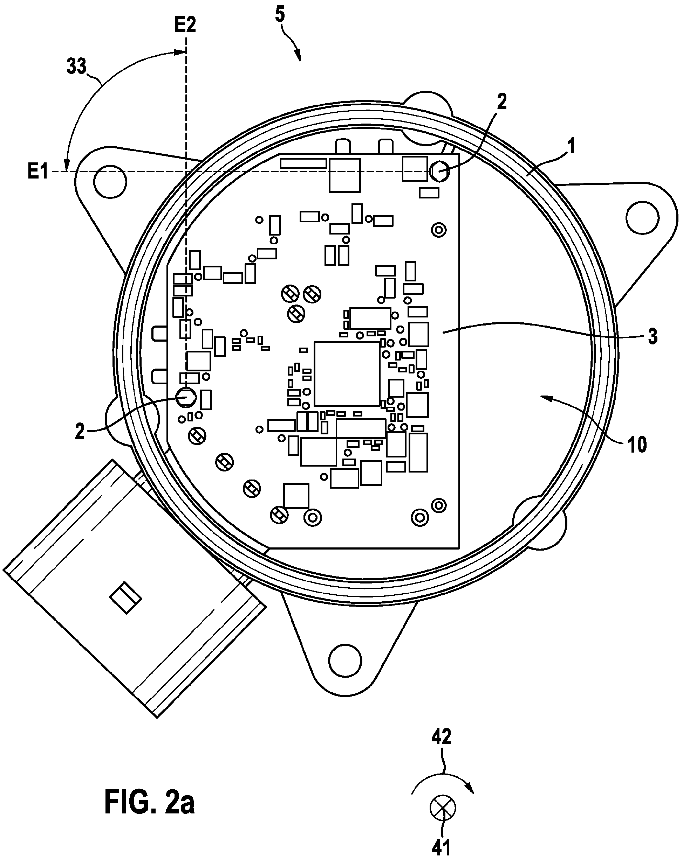

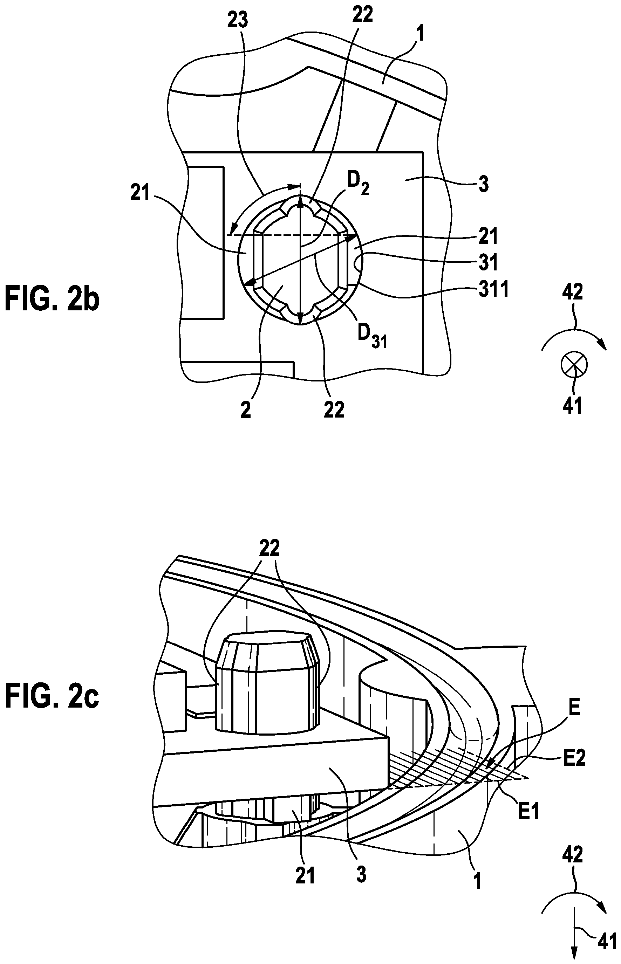

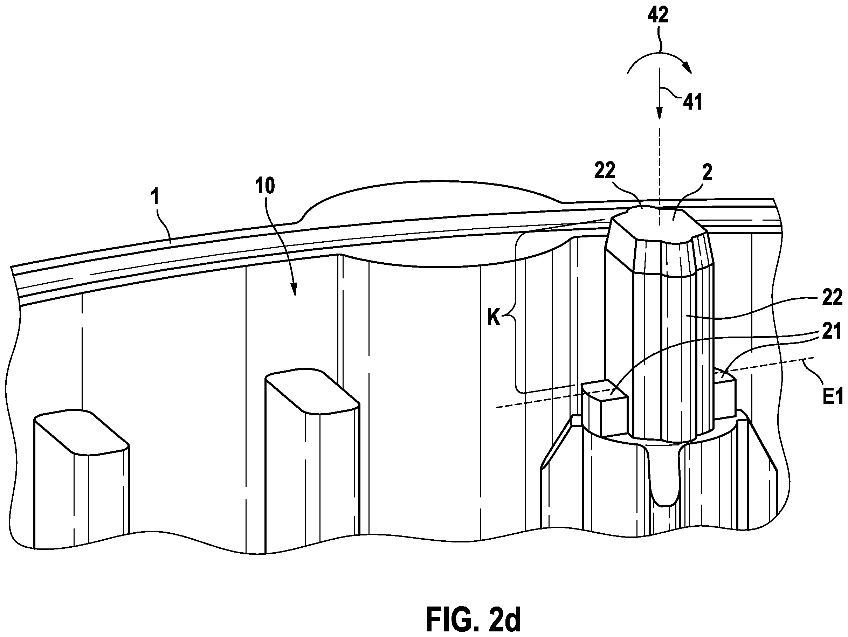

- **Fig. 2**: zeigt in (a) ein erfindungsgemäßes Gehäusebauteil für einen Elektromotor eines Verstellantriebs eines Kraftfahrzeugs mit einer elektrischen Leiterplatte von oben, in (b) einen Ausschnitt aus dem Gehäusebauteil von oben, in (c) einen Ausschnitt aus dem Gehäusebauteil in einer perspektivischen Ansicht, und in (d) einen Ausschnitt aus dem Gehäusebauteil in einer perspektivischen Ansicht und ohne die elektrische Leiterplatte; und

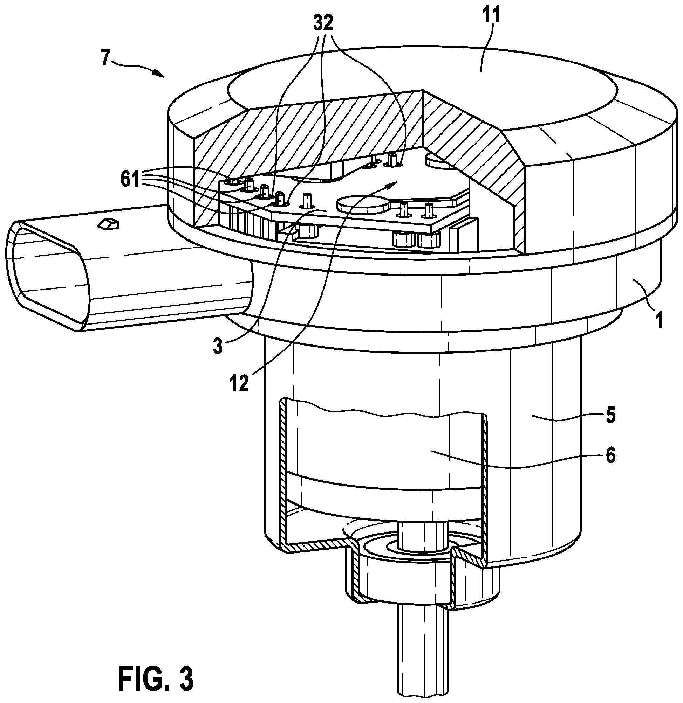

- **Fig. 3**: zeigt einen Verstellantrieb für den Motorraum eines Kraftfahrzeugs mit dem erfindungsgemäßen Gehäusebauteil.

**Fig. 1** zeigt in (a) - (c) jeweils einen Ausschnitt aus einem Gehäusebauteil 1 eines Verstellantriebs 7 (s. **Fig. 3**) zum Verstellen von Komponenten (nicht gezeigt) eines Kraftfahrzeugs (nicht gezeigt), beispielsweise zum Verstellen eines Fensters, Sitzes oder einer Heckklappe, nach dem Stand der Technik.

In einem Innenraum 10 des Gehäusebauteils 1 ist eine elektrische Leiterplatte 3 angeordnet, die elektrisch mit einem Elektromotor 6 (s. **Fig. 3**) des Verstellantriebs 7 verbunden ist.

Dafür sind Positionierstifte 2 vorgesehen, mit denen die elektrische Leiterplatte 3 während der Montage eingefangen und positioniert wird. Die Leiterplatte 3 liegt auf separaten Auflagestegen 24 auf und ist mittels separaten Schnappbügeln 25 fixiert.

**Fig. 2** zeigt einen Ausschnitt aus einem Gehäusebauteil 1 eines Verstellantriebs 7 gemäß der Erfindung.

Im Innenraum 10 des Gehäusebauteils 1 ist ein Positionierstift 2 angeordnet, der zum Anordnen einer elektrischen Leiterplatte 3 vorgesehen ist. Das Gehäusebauteil 1 ist mit dem Positionierstift 2 einstückig aus einem Kunststoff gefertigt.

Der Positionierstift 2 weist zwei Anschläge 21 auf, mit denen eine Bewegung der Leiterplatte 3 in eine Erstreckungsrichtung 41 des Positionierstiftes 2 begrenzt ist.

Zudem weist er zwei Mittel 22 zum Verklemmen der elektrischen Leiterplatte 3 während der Montage auf, die in einem Klemmbereich K des Positionierstiftes 2 angeordnet sind. Der Klemmbereich K ist in Erstreckungsrichtung 41 oberhalb des Anschlags 21 angeordnet.

Die Mittel 22 zum Verklemmen der elektrischen Leiterplatte 3 sind als Anformungen stegförmig ausgebildet und erstrecken sich in die Erstreckungsrichtung 41. Im Folgenden werden die Begriffe Anformung und Mittel 22 zum Verklemmen synonym verwendet.

Der Positionierstift 2 vereint daher die Funktionen Positionieren, Auflage und Verklemmen der elektrischen Leiterplatte 3 in einem Bauelement. Im Vergleich zu dem in der **Fig. 1** gezeigten Stand der Technik werden daher durch ihn Auflagestege 24 und Schnappbügel 25 eingespart. Dennoch ermöglicht er eine sowohl händische als auch automatisierte Montage der Leiterplatte 3 auf den Positionierstift 2.

Dafür weist die Leiterplatte 3 eine Durchgangsbohrung 31 auf, die während der Montage in Erstreckungsrichtung 41 auf den Positionierstift 2 aufgeschoben wird, bis die Leiterplatte 3 an den Anschlägen 21 anschlägt und der Positionierstift 2 die Durchgangsbohrung 31 durchgreift.

Der Positionierstift 2 weist im Klemmbereich K einen sich in eine Umfangsrichtung 42 des Positionierstiftes 2 ändernden Durchmesser D₂ auf. Sichtbar ist, dass der Durchmesser D₂ des Positionierstiftes 2 im Bereich der Anformungen 22 am größten ausgebildet ist, und größer, als ein Durchmesser D₃₁ der Durchgangsbohrung 31.

Beim Aufschieben der Leiterplatte 3 auf den Positionierstift 2 gleitet oder schabt ein Rand 311 der Durchgangsbohrung 31 daher entlang den Anformungen 22. Dadurch entsteht zwischen den Anformungen 22 und der Leiterplatte 3 beim Aufschieben eine form- und/oder kraftschlüssige Klemmverbindung.

Die Anformungen 22 sind um eine Versatzwinkel 23 von 90° zu den Anschlägen 21 versetzt angeordnet. Ein beim Aufschieben gegebenenfalls entstehender Abrieb, beispielsweise in Form von Spänen, fällt daher beim Aufschieben nicht zwischen die Anschläge 21 und die Leiterplatte 3 und erhöht daher eine Ebene E, in der die Leiterplatte 3 im Gehäusebauteil 1 angeordnet ist, nicht.

Im gezeigten Ausführungsbeispiel sind zwei Positionierstifte 2 zum Anordnen und Befestigen der Leiterplatte 3 vorgesehen, die um einen Drehwinkel 33 von 90° zueinander versetzt angeordnet sind. Die Ebene E, in der die Leiterplatte 3 im Gehäusebauteil 1 angeordnet ist, ist dadurch durch zwei Linien E1, E2 aufgespannt, die sich jeweils in Richtung der Anschläge 21 erstrecken. Durch diese Ausbildung der Anschläge 21 als Auflageflächen wird die Leiterplatte 3 nicht verspannt und ein Durchbiegen der Leiterplatte 3 vermieden.

Während der Herstellung des Verstellantriebs 7 wird somit die elektrische Leiterplatte 3 auf den Positionierstift 2 des Gehäusebauteils 1 in Erstreckungsrichtung 41 aufgeschoben. Dabei wird die Leiterplatte 3 am Positionierstift 2 verklemmt. Der Positionierstift 2 weist zumindest geringfügige elastische Eigenschaften auf, so dass das Aufschieben der Leiterplatte 3 auf den Positionierstift 2 sehr leicht möglich und die Leiterplatte nach dem Aufschieben nicht mehr beschädigungsfrei vom Positionierstift lösbar ist.

Anschließend werden elektrische Kontakte 32 (s. **Fig. 3****)** der Leiterplatte 3 durch Löten mit elektrischen Gegenkontakten 61 (s. **Fig. 3**), die mit dem Elektromotor 6 (s. **Fig. 3**) elektrisch verbunden sind, verbunden. Dadurch wird die Leiterplatte 3 am Elektromotor 6 am Gehäusebauteil 1 zusätzlich und endgültig fixiert. Auch bei einem späteren Erwärmen oder Kriechen des Kunststoffs der Positionierstifte 2 beziehungsweise der Anformungen 22 bleibt die Leiterplatte 3 daher sicher fixiert.

Als weitere Abstützung kann zwischen einem Gehäusedeckel 11 des Gehäusebauteils 1 und der Leiterplatte 3 eine Wärmeleitpaste (nicht gezeigt) vorgesehen sein, die einen Spalt 12 zwischen dem Gehäusedeckel 11 und der Leiterplatte 3 spielfrei ausfüllt.

**Fig. 3** zeigt einen Ausschnitt aus dem Verstellantrieb 7, der im Motorraum (nicht gezeigt) eines Kraftfahrzeugs (nicht gezeigt) zum Verstellen und/oder Regeln von Komponenten (nicht gezeigt) genutzt wird. Sichtbar sind der Elektromotor 6 und die Gehäuseanordnung 5 mit dem Gehäusebauteil 1 und der Leiterplatte 3.

An der Leiterplatte 3 sind elektrische Kontakte 32 vorgesehen, die hier als Kontaktflächen ausgebildet sind. In den Kontaktflächen 32 sind jeweils Durchbohrungen vorgesehen, die hier der Übersichtlichkeit halber nicht zusätzlich bezeichnet sind, und durch die elektrische Gegenkontakte 61, die hier als Stiftkontakte ausgebildet sind, durchgeführt sind. Im Folgenden werden die Begriffe Kontaktfläche und elektrischer Kontakt 32, sowie Stiftkontakt und elektrischer Gegenkontakt 61 synonym verwendet. Die Stiftkontakte 61 sind elektrisch mit dem Elektromotor 6 verbunden und von außen zugänglich.

Nach dem Aufschieben der Leiterplatte 3 auf die Positionierstifte 2 werden die Kontaktflächen 32 mit den Stiftkontakten 61 durch Verlöten miteinander elektrisch verbunden. Die Leiterplatte 3 ist dadurch endgültig mechanisch fixiert.

## Patentansprüche

1. Gehäusebauteil (1), insbesondere eines Verstellantriebs eines Kraftfahrzeugs, mit einem Positionierstift (2) zum Anordnen einer elektrischen Leiterplatte (3) in einem Innenraum (10) des Gehäusebauteils (1), wobei der Positionierstift (2) einen Anschlag (21) zum Begrenzen der Bewegung der Leiterplatte (3) in eine Erstreckungsrichtung (41) des Positionierstiftes (2) aufweist, wobei
er ein Mittel (22) zum Verklemmen der elektrischen Leiterplatte (3) aufweist, das in einem Klemmbereich (K) in Erstreckungsrichtung (20) oberhalb des Anschlags (21) angeordnet ist, wobei
der Positionierstift (2) zwei einander gegenüberliegende Mittel (22) zum Verklemmen der elektrischen Leiterplatte (3) und zwei einander gegenüberliegende Anschläge (21) aufweist, wobei die Mittel (22) zum Verklemmen gegenüber den Anschlägen (21) jeweils um einen Versatzwinkel (23) zueinander versetzt angeordnet sind, und die Mittel (22) zum Verklemmen der elektrischen Leiterplatte (3) Anformungen sind, die als in Erstreckungsrichtung (41) stegförmige Quetschrippen ausgebildet sind, die eine Presspassung mit der Leiterplatte (3) ausbilden.

2. Gehäusebauteil (1) nach Anspruch 1, **dadurch gekennzeichnet, dass** aufgrund des Versatzwinkels (23) kein Abrieb zwischen die Anschläge (21) und die Leiterplatte (3) gerät.

3. Gehäusebauteil (1) nach einem der vorherigen Ansprüche, **dadurch gekennzeichnet, dass** der Versatzwinkel (23) 90° beträgt.

4. Gehäusebauteil (1) nach einem der vorherigen Ansprüche, **dadurch gekennzeichnet, dass** das Gehäusebauteil (1) mit dem Positionierstift (2) einstückig gefertigt ist, insbesondere aus einem Kunststoff.

5. Gehäusebauteil (1) nach einem der vorherigen Ansprüche, **dadurch gekennzeichnet, dass** der Positionierstift (2) im Klemmbereich (K) einen sich in einer Umfangsrichtung (42) des Positionierstiftes (2) ändernden Durchmesser (D₂) aufweist

6. Gehäusebauteil (1) nach einem der vorherigen Ansprüche, **dadurch gekennzeichnet, dass** zwei Positionierstifte (2) zum Anordnen und Befestigen der Leiterplatte (3) vorgesehen sind, die um einen Drehwinkel (33) von 90° zueinander versetzt angeordnet sind.

7. Gehäuseanordnung (5) mit einem Gehäusebauteil (1) nach einem der vorherigen Ansprüche und einer elektrischen Leiterplatte (3), wobei die Leiterplatte (3) eine Durchgangsbohrung (31) aufweist und der Positionierstift (2) die Durchgangsbohrung (31) durchgreift.

8. Gehäuseanordnung (5) nach Anspruch 7, **dadurch gekennzeichnet, dass** der Durchmesser (D₂) des Positionierstiftes (2) im Bereich der Mittel (22) zum Verklemmen der elektrischen Leiterplatte (3) jeweils größer als ein Durchmesser (D₃₁) der Durchgangsbohrung (31) ist.

9. Elektrische Vorrichtung (7), insbesondere Verstellantrieb, mit einer elektrischen Maschine (6), insbesondere mit einem Elektromotor, sowie mit einer Gehäuseanordnung (5) nach einem der Ansprüche 7 - 8, wobei die elektrische Leiterplatte (3) mit der elektrischen Maschine (6) elektrisch verbunden ist.

10. Verfahren zur Herstellen einer elektrischen Vorrichtung (7) nach Anspruch 9, insbesondere eines Verstellantriebs für ein Kraftfahrzeug, mit den Schritten:
• Aufschieben einer elektrischen Leiterplatte (3) auf einen Positionierstift (2) eines Gehäusebauteils (1) in Erstreckungsrichtung (41) des Positionierstiftes (2), wobei die Leiterplatte (3) am Positionierstift (2) verklemmt wird; und
• Gleichzeitig und/oder anschließend elektrisches Verbinden von elektrischen Kontakten (32) der Leiterplatte (3) mit elektrischen Gegenkontakten (61), die mit der elektrischen Maschine (6) elektrisch verbunden sind.

11. Verfahren nach Anspruch 10, **dadurch gekennzeichnet, dass** das elektrische Verbinden ein anschließendes Verlöten der elektrischen Kontakte (32) mit den elektrischen Gegenkontakten (61) ist.

## Claims

1. Housing component (1), in particular of an adjusting drive of a motor vehicle, comprising a positioning pin (2) for arranging an electrical circuit board (3) in an internal space (10) of the housing component (1), wherein the positioning pin (2) has a stop (21) for limiting the movement of the circuit board (3) in an extension direction (41) of the positioning pin (2), wherein
it has a means (22) for clamping the electrical circuit board (3), which is arranged in a clamping region (K) in the extension direction (20) above the stop (21), wherein
the positioning pin (2) has two mutually opposite means (22) for clamping the electrical circuit board (3) and two mutually opposite stops (21), wherein the means (22) for clamping with respect to the stops (21) are each arranged to be offset relative to each other by an offset angle (23), and the means (22) for clamping the electrical circuit board (3) are shaped pieces, which are formed in the extension direction (41) as web-like compression ribs which form a press fit with the printed circuit board (3).

2. Housing component (1) according to Claim 1, **characterized in that**, because of the offset angle (23), no vibration occurs between the stops (21) and the circuit board (3).

3. Housing component (1) according to one of the preceding claims, **characterized in that** the offset angle (23) is 90°.

4. Housing component (1) according to one of the preceding claims, **characterized in that** the housing component (1) is made in one piece with the positioning pin (2), in particular from a plastic.

5. Housing component (1) according to one of the preceding claims, **characterized in that** in the clamping region (K), the positioning pin (2) has a diameter (D₂) which changes in the circumferential direction (42) of the positioning pin (2).

6. Housing component (1) according to one of the preceding claims, **characterized in that** two positioning pins (2) for arranging and fixing the circuit board (3) are provided, which are arranged to be offset relative to each other by an angle of rotation (33) of 90°.

7. Housing assembly (5) having a housing component (1) according to one of the preceding claims and an electrical circuit board (3), wherein the circuit board (3) has a passage opening (31) and the positioning pin (2) engages through the passage opening (31).

8. Housing assembly (5) according to Claim 7, **characterized in that** the diameter (D₂) of the positioning pin (2) in the region of the means (22) for clamping the electrical circuit board (3) is in each case larger than a diameter (D₃₁) of the passage opening (31).

9. Electrical device (7), in particular adjusting drive, having an electrical machine (6), in particular having an electric motor, and having a housing assembly (5) according to one of Claims 7 - 8, wherein the electrical circuit board (3) is connected electrically to the electrical machine (6) .

10. Method for producing an electrical device (7) according to Claim 9, in particular an adjusting drive for a motor vehicle, having the steps:
• pushing an electrical circuit board (3) onto a positioning pin (2) of a housing component (1) in the extension direction (41) of the positioning pin (2), wherein the circuit board (3) is clamped on the positioning pin (2); and
• simultaneously and/or subsequently connecting electric contacts (32) of the circuit board (3) to mating electric contacts (61) which are connected electrically to the electrical machine (6).

11. Method according to Claim 10, **characterized in that** the electrical connection is subsequent soldering of the electric contacts (32) to the mating electric contacts (61).

## Revendications

1. Composant de boîtier (1), en particulier d'un entraînement de déplacement d'un véhicule automobile, avec une tige de positionnement (2) pour agencer une carte de circuits imprimés électrique (3) dans un espace intérieur (10) du composant de boîtier (1), dans lequel la tige de positionnement (2) présente une butée (21) pour limiter le mouvement de la carte de circuits imprimés (3) dans une direction d'extension (41) de la tige de positionnement (2),
dans lequel il présente un moyen (22) pour serrer la carte de circuits imprimés électrique (3), qui est disposé dans une région de serrage (K) dans la direction d'extension (20) au-dessus de la butée (21),
dans lequel la tige de positionnement (2) présente deux moyens opposés l'un à l'autre (22) pour serrer la carte de circuits imprimés électrique (3) et deux butées opposées l'une à l'autre (21),
dans lequel les moyens de serrage (22) sont disposés par rapport aux butées (21) chaque fois de façon décalée d'un angle de décalage (23) l'un par rapport à l'autre, et les moyens (22) pour serrer la carte de circuits imprimés électrique (3) sont des protubérances, qui sont réalisées sous forme d'ailettes d'écrasement ayant la forme de nervures dans la direction d'extension (41), qui forment un ajustement serré avec la carte de circuits imprimés (3) .

2. Composant de boîtier (1) selon la revendication 1, **caractérisé en ce qu'**en raison de l'angle de décalage (23) il ne se produit aucune abrasion entre les butées (21) et la carte de circuits imprimés (3).

3. Composant de boîtier (1) selon l'une quelconque des revendications précédentes, **caractérisé en ce que** l'angle de décalage (23) vaut 90°.

4. Composant de boîtier (1) selon l'une quelconque des revendications précédentes, **caractérisé en ce que** le composant de boîtier (1) est fabriqué d'une seule pièce avec la tige de positionnement (2), en particulier en une matière plastique.

5. Composant de boîtier (1) selon l'une quelconque des revendications précédentes, **caractérisé en ce que** la tige de positionnement (2) présente dans la région de serrage (K) un diamètre (D₂) variant dans une direction périphérique (42) de la tige de positionnement (2).

6. Composant de boîtier (1) selon l'une quelconque des revendications précédentes, **caractérisé en ce qu'**il est prévu deux tiges de positionnement (2) pour agencer et fixer la carte de circuits imprimés (3), qui sont disposées de façon décalée l'une par rapport à l'autre d'un angle de rotation (33) de 90°.

7. Dispositif de boîtier (5) comportant un composant de boîtier (1) selon l'une quelconque des revendications précédentes et une carte de circuits imprimés électrique (3), dans lequel la carte de circuits imprimés (3) présente un trou de passage (31) et la tige de positionnement (2) traverse le trou de passage (31).

8. Dispositif de boîtier (5) selon la revendication 7, **caractérisé en ce que** le diamètre (D₂) de la tige de positionnement (2) est chaque fois plus grand dans la région des moyens (22) pour serrer la carte de circuits imprimés électrique (3) qu'un diamètre (D₃₁) du trou de passage (31).

9. Dispositif électrique (7), en particulier entraînement de déplacement, comportant une machine électrique (6), en particulier un moteur électrique, ainsi qu'un dispositif de boîtier (5) selon une des revendications 7 à 8, dans lequel la carte de circuits imprimés électrique (3) est électriquement reliée à la machine électrique (6).

10. Procédé de fabrication d'un dispositif électrique (7) selon la revendication 9, en particulier d'un entraînement de déplacement pour un véhicule automobile, comportant les étapes suivantes:
• engager une carte de circuits imprimés électrique (3) sur une tige de positionnement (2) d'un composant de boîtier (1) dans la direction d'extension (41) de la tige de positionnement (2), dans lequel on serre la carte de circuits imprimés (3) sur la tige de positionnement (2); et
• simultanément et/ou ensuite relier électriquement des contacts électriques (32) de la carte de circuits imprimés (3) à des contacts électriques opposés (61), qui sont en liaison électrique avec la machine électrique (6).

11. Procédé selon la revendication 10, **caractérisé en ce que** la liaison électrique est un brasage de raccordement des contacts électriques (32) avec les contacts électriques opposés (61).
